# EUROPEAN PATENT SPECIFICATION

(11) **EP 4 002 449 B1**
(45) Date of publication and mention of the grant of the patent: **12.02.2025**
(21) Application number: 21206106.3
(22) Date of filing: 03.11.2021
(51) Int. Cl.: H01L 23/495, H01L 23/31

(54) **INTEGRATED CIRCUIT PACKAGE WITH V-SHAPED NOTCH CREEPAGE STRUCTURE**
INTEGRIERTES SCHALTUNGSGEHÄUSE MIT KRIECHSTRUKTUR MIT V-FÖRMIGER EINKERBUNG
BOÎTIER DE CIRCUIT INTÉGRÉ AVEC STRUCTURE DE FLUAGE D'ENCOCHE EN FORME DE V

(30) Priority: 17.11.2020 US 202063114602 P; 05.10.2021 US 202117494298
(43) Date of publication of application: 25.05.2022
(73) Proprietor: STMicroelectronics Sdn Bhd, 84007 Muar (MY)
(72) Inventor: HENG, Yang Hong, 84000 Muar (MY)
(74) Representative: Cabinet Beaumont

(56) References cited:
- JP-A- S5 998 565
- JP-A- S6 218 803
- JP-A- S63 265 451
- US-A1- 2007 052 072
- US-A1- 2012 326 289

## Description

### TECHNICAL FIELD

The present invention generally relates to a package for an integrated circuit device that includes a V-shaped notch creepage structure formed in a peripheral package sidewall between external electrical terminals to ensure a sufficient creepage distance between those external electrical terminals.

### BACKGROUND

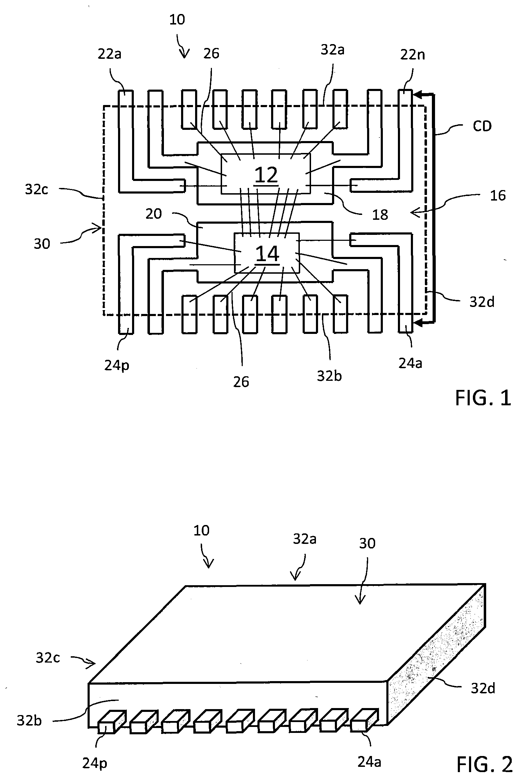

Reference is made to Figures 1 and 2. A power integrated circuit device 10 typically includes a first integrated circuit chip 12 which provides a power element (or function) and a second integrated circuit chip 14 which provides a control element (or function). The lead frame 16 for the power integrated circuit device 10 includes a first die pad 18 to which the first integrated circuit chip 12 is mounted and a second die pad 20 to which the second integrated circuit chip 14 is mounted. A first set of leads 22a-22n extend away from the first die pad 18 and a second set of leads 24a-24p extend away from the second die pad 20. A first set of pads of the first integrated circuit chip 12 are electrically connected to the proximal ends of the first set of leads 22a-22n by bonding wires 26, and a first set of pads of the second integrated circuit chip 14 are electrically connected to the proximal ends of the second set of leads 24a-24p by bonding wires 26. A second set of pads of the first integrated circuit chip 12 are electrically connected to a second set of pads of the second integrated circuit chip 14 by bonding wires 26. A package 30 typically made of a resin material encapsulates the first and second integrated circuit chips 12 and 14, the lead frame 16 and the bonding wires 26. The package 30 has in top view a square or rectangular shaped perimeter defined by peripheral package sidewalls 32. In the illustrated embodiment, distal ends of the leads 22 and 24 extend out from opposite peripheral package sidewalls 32a and 32b. Opposite peripheral package sidewalls 32c and 32d extend perpendicular to and respectively join the opposite peripheral package sidewalls 32a and 32b.

As power integrated circuit devices 10 continue to become smaller in size, especially in terms of occupied area, the distance between the distal ends of ones of the first set of leads 22a-22n and the ends of ones of the second set of leads 24a-24p becomes shorter. This increases the risk that an electrical arc can form along the one of the opposite sides 32c and 32d of the peripheral package sidewall (for example, between lead 22n and lead 24a) because the creepage distance CD has been shortened. There is a need in the art to address this concern.

JPS63265451A is directed to a semiconductor device. US20120326289A1 is directed to a semiconductor device and a method of fabricating the same. JPS5998565 is directed to a molded package with increased creepage distance.

### SUMMARY

An embodiment provides an integrated circuit as recited in claim 1. 1

According to an embodiment, the package encapsulates a first integrated circuit chip and a second integrated circuit chip, the first integrated circuit chip being mounted to a first die pad of the lead frame and electrically connected to a first plurality of leads of the lead frame, the second integrated circuit chip being mounted to a second die pad of the lead frame and electrically connected to a second plurality of leads of the lead frame.

According to an embodiment, the first and second integrated circuit chips are electrically connected to each other.

According to an embodiment, the first integrated circuit chip is a power chip and the second integrated circuit chip is a control chip configured to control operation of the power chip.

According to an embodiment, each of the third and fourth sidewalls includes said V-shaped concavity.

According to an embodiment, the first outside corner is defined by an outside angle α between the first sidewall portion and the second sidewall portion, and wherein the second outside corner is defined by the outside angle α between the third sidewall portion and the fourth sidewall portion.

According to an embodiment, the inside corner is defined by an inside angle β between the second sidewall portion and the third sidewall portion.

According to an embodiment, the outside angle α sets a width of the V-shaped concavity.

According to an embodiment, the outside angle α sets a depth of the V-shaped concavity.

According to an embodiment, the package has a thickness, and wherein the V-shaped concavity extends completely through said thickness.

### BRIEF DESCRIPTION OF THE DRAWINGS

For a better understanding of the embodiments, reference will now be made by way of example only to the accompanying figures in which:
Figure 1 is a schematic top view and Figure 2 is a perspective view, respectively, of a power integrated circuit device; and
Figure 3 is a schematic top view and Figure 4 is a perspective view, respectively, of a power integrated circuit device that includes a V-shaped notch creepage structure formed in a peripheral package sidewall.

### DETAILED DESCRIPTION

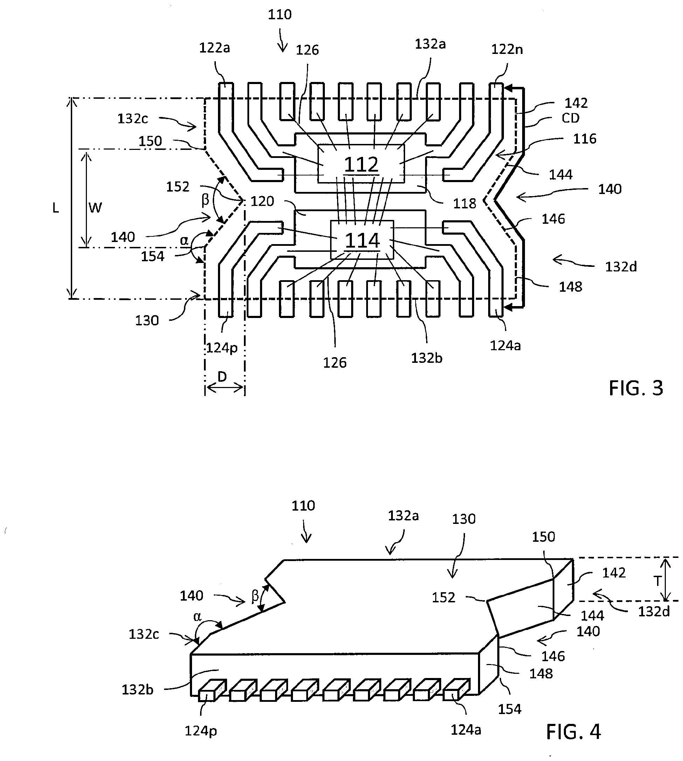

Reference is made to Figures 3 and 4. A power integrated circuit device 110 includes a first integrated circuit chip 112 which provides a power element (function) and a second integrated circuit chip 114 which provides a control element (function). The lead frame 116 for the power integrated circuit device 110 includes a first die pad 118 to which the first integrated circuit chip 112 is mounted and a second die pad 120 to which the second integrated circuit chip 114 is mounted. A first set of leads 122a-122n extend away from the first die pad 118 and a second set of leads 124a-124p extend away from the second die pad 120. A first set of pads of the first integrated circuit chip 112 are electrically connected to the proximal ends of the first set of leads 122a-122n by bonding wires 126, and a first set of pads of the second integrated circuit chip 114 are electrically connected to the proximal ends of the second set of leads 124a-124p by bonding wires 126. A second set of pads of the first integrated circuit chip 112 are electrically connected to a second set of pads of the second integrated circuit chip 114 by bonding wires 126.

A package 130 typically made of a resin material encapsulates the first and second integrated circuit chips 112 and 114, the lead frame 116 and the bonding wires 126. The package 130 has in top view a square or rectangular shaped perimeter defined by peripheral package sidewalls 132. In the illustrated embodiment, distal ends of the leads 122 and 124 extend out from opposite peripheral package sidewalls 132a and 132b. Opposite peripheral package sidewalls 132c and 132d respectively join the opposite peripheral package sidewalls 132a and 132b. The opposite peripheral package sidewalls 132c and 132d differ from the opposite peripheral package sidewalls 32c and 32d of Figures 1 and 2 in that each peripheral package sidewall 132c and 132d includes a V-shaped concavity 140 provided across an entire thickness T between top and bottom surfaces of the package 130. Each of the peripheral package sidewalls 132c and 132d is defined by a first sidewall portion 142, a second sidewall portion 144 joined to the first sidewall portion 142 at an outside corner 150, a third sidewall portion 146 joined to the second sidewall portion 144 at an inside corner 152, and a fourth sidewall portion 148 joined to the third sidewall portion 146 at an outside corner 154. The outside corner 150 is defined by an outside angle α between the first sidewall portion 142 and the second sidewall portion 144. The inside corner 152 is defined by an inside angle β between the second sidewall portion 144 and the third sidewall portion 146. The outside corner 154 is defined by an outside angle α between the third sidewall portion 146 and the fourth sidewall portion 148. The first sidewall portion 142 extends perpendicularly from the peripheral package sidewall 132a, and the fourth sidewall portion 148 extends perpendicularly from the peripheral package sidewall 132b.

The presence of the V-shaped concavity 140 in each of the peripheral package sidewalls 132c and 132d provides for a creepage distance CD that is longer than is present in the embodiment shown in Figures 1 and 2. The second integrated circuit chip 114 which provides a control element may be exposed to a relatively lower voltage (for example, less than or equal to 24V) while the first integrated circuit chip 112 which provides a power element may be exposed to a relatively higher voltage (for example, approximately 4,000V). A minimum creepage distance at the outer surface of the package 130 is required to have sufficient electrical insulation between the two integrated circuit chips (in particular, between one of the leads 122 for the first integrated circuit chip 112 and one of the leads 124 for the second integrated circuit chip 114). With use of the V-shaped concavity 140 in the peripheral package sidewalls 132c and 132d, the package 130 may occupy a smaller area while still satisfying the minimum creepage distance requirement.

Provision of the 130 with V-shaped concavities 140 on opposite peripheral package sidewall 132c and 132d is accomplished through the use of well-known transfer molding technology, but where the mold cavity is formed to define the concavity. Additionally, the lead frame 116 is designed in a way that the leads 122 or 124 are routed to not extend into the area where the V-shaped concavity 140 will be present. This is accomplished, for example, by forming or shaping outer leads extending from the die pads 118 and 120 with a bend to avoid the area of the V-shaped concavity 140.

The V-shaped concavity 140 formed by the second sidewall portion 144 and third sidewall portion 146 has a width W defined between the outside corners 150 and 154 that is between 0.35*L and 0.55*L, where L is a length of the peripheral package sidewall 132c, 132d. The width W is set, at least in part, by the choice of the angles α and/or β.

The V-shaped concavity 140 formed by the second sidewall portion 144 and third sidewall portion 146 has a depth D from the plane defined by the first sidewall portion 142 and fourth sidewall portion 148 to the corner 152 that is between 0.15*L and 0.30*L. The depth D is set, at least in part, by the choice of the angles α and/or β.

In a preferred implementation, the inside corner 152 for the V-shaped concavity 140 is positioned substantially midway between the opposite peripheral package sidewalls 132a and 132b. However, this is not a requirement and positioning of the V-shaped concavity 140 is typically driven by the relative shape and configuration of the lead frame 116. The example lead frame 116 shown in Figure 3 is symmetric and generally mirror imaged, but this is not a requirement. In the case of an asymmetric shape and configuration for the lead frame 116, the V-shaped concavity 140 may instead be positioned along the peripheral package sidewall closer to one or the other of the opposite peripheral package sidewalls 132a and 132b.

In an embodiment, the integrated circuit device 110 may instead comprise a single integrated circuit chip that is mounted to a single die pad of the lead frame 116 and electrically connected to the first set of leads 122a-122n and second set of leads 124a-124p.

## Claims

1. An integrated circuit device (110), comprising:
a package (130) that encapsulates a lead frame (116) and at least one integrated circuit chip (112, 114), wherein the at least one integrated circuit chip is mounted to a die pad (118, 120) of the lead frame, said lead frame further including a plurality of leads (122, 124);
wherein the package has, in top view, a square or rectangular perimeter defined by first, second, third and fourth sidewalls (132);
wherein first (132a) and second (132b) sidewalls are opposite each other;
wherein third (132c) and fourth (132d) sidewalls are opposite each other;
wherein a first set (122) of the plurality of leads extend along the first sidewall and a second set (124) of the plurality of leads extend along the second sidewall; and
wherein at least one of the third and fourth sidewalls includes a V-shaped concavity (140) and comprises:
a first sidewall portion (142);
a second sidewall portion (144) joined to the first sidewall portion at a first outside corner (150);
a third sidewall portion (146) joined to the second sidewall portion at an inside corner (152); and
a fourth sidewall portion (148) joined to the third sidewall portion at a second outside corner (154);
wherein the second sidewall portion and the third sidewall portion define the V-shaped concavity;
wherein the first sidewall portion (142) extends perpendicularly from the first sidewall (132a), and the fourth sidewall portion (148) extends perpendicularly from the second sidewall (132b),
**characterized in that**
the V-shaped concavity has a width (W) between the first and second outside corners that is between 0.35*L and 0.55*L, where L is a length of the third or fourth sidewall, and has a depth (D) from a plane of the third or fourth sidewall that is between 0.15*L and 0.30*L.

2. The integrated circuit device of claim 1, wherein the package (130) encapsulates a first integrated circuit chip (112) and a second integrated circuit chip (114), the first integrated circuit chip being mounted to a first die pad (118) of the lead frame and electrically connected to a first plurality of leads (122) of the lead frame, the second integrated circuit chip being mounted to a second die pad (120) of the lead frame and electrically connected to a second plurality of leads (124) of the lead frame.

3. The integrated circuit device of claim 2, wherein the first and second integrated circuit chips are electrically connected to each other.

4. The integrated circuit device of claim 2 or 3, wherein the first integrated circuit chip is a power chip and the second integrated circuit chip is a control chip configured to control operation of the power chip.

5. The integrated circuit device of any of claims 1 to 4, wherein each of the third and fourth sidewalls includes said V-shaped concavity.

6. The integrated circuit device of any of claims 1 to 5, wherein the first outside corner is defined by an outside angle α between the first sidewall portion and the second sidewall portion, and wherein the second outside corner is defined by the outside angle α between the third sidewall portion and the fourth sidewall portion.

7. The integrated circuit device of any of claims 1 to 6, wherein the inside corner is defined by an inside angle β between the second sidewall portion and the third sidewall portion.

8. The integrated circuit device of claims 6 or 7, wherein the outside angle α sets a width (W) of the V-shaped concavity.

9. The integrated circuit device of any of claims 6 to 8, wherein the outside angle α sets a depth (D) of the V-shaped concavity.

10. The integrated circuit device of any of claims 1 to 9, wherein the package has a thickness (T), and wherein the V-shaped concavity extends completely through said thickness.

## Patentansprüche

1. Eine integrierte Schaltungsvorrichtung (110), die Folgendes aufweist:
ein Paket (130), das einen Leiterrahmen (116) und wenigstens einen integrierten Schaltungschip (112, 114) einkapselt, wobei der wenigstens eine integrierte Schaltungschip an einem Die-Pad (118, 120) des Leiterrahmens befestigt ist, wobei der Leiterrahmen ferner eine Vielzahl von Leitern (122, 124) enthält;
wobei das Paket in der Draufsicht einen quadratischen oder rechteckigen Umfang hat, der durch eine erste, zweite, dritte und vierte Seitenwand (132) definiert ist;
wobei die erste (132a) und die zweite (132b) Seitenwand einander gegenüberliegen;
wobei die dritte (132c) und vierte (132d) Seitenwand einander gegenüberliegen;
wobei ein erster Satz (122) der Vielzahl von Leitern sich entlang der ersten Seitenwand erstreckt und ein zweiter Satz (124) der Vielzahl von Leitern sich entlang der zweiten Seitenwand erstreckt; und
wobei wenigstens eine der dritten und vierten Seitenwände eine V-förmige Vertiefung (140) aufweist und Folgendes aufweist:
einen ersten Seitenwandabschnitt (142);
einen zweiten Seitenwandabschnitt (144), der mit dem ersten Seitenwandabschnitt an einer ersten Außenecke (150) verbunden ist;
einen dritten Seitenwandabschnitt (146), der mit dem zweiten Seitenwandabschnitt an einer Innenecke (152) verbunden ist; und
einen vierten Seitenwandabschnitt (148), der mit dem dritten Seitenwandabschnitt an einer zweiten Außenecke (154) verbunden ist;
wobei der zweite Seitenwandabschnitt und der dritte Seitenwandabschnitt die V-förmige Vertiefung definieren;
wobei der erste Seitenwandabschnitt (142) sich senkrecht von der ersten Seitenwand (132a) erstreckt und der vierte Seitenwandabschnitt (148) sich senkrecht von der zweiten Seitenwand (132b) erstreckt, und
**dadurch gekennzeichnet, dass** die V-förmige Vertiefung eine Breite (W) zwischen der ersten und der zweiten Außenecke zwischen 0,35*L und 0,55*L hat, wobei L eine Länge der dritten oder vierten Seitenwand ist, und eine Tiefe (D) von einer Ebene der dritten oder vierten Seitenwand aus hat, die zwischen 0,15*L und 0,30*L liegt.

2. Die integrierte Schaltungsvorrichtung nach Anspruch 1, wobei das Paket (130) einen ersten integrierten Schaltungschip (112) und einen zweiten integrierten Schaltungschip (114) einkapselt, wobei der erste integrierte Schaltungschip an einem ersten Die-Pad (118) des Leiterrahmens befestigt und elektrisch mit einer ersten Vielzahl von Leitungen (122) des Leiterrahmens verbunden ist, wobei der zweite integrierte Schaltungschip an einem zweiten Die-Pad (120) des Leiterrahmens befestigt und elektrisch mit einer zweiten Vielzahl von Leitungen (124) des Leiterrahmens verbunden ist.

3. Die integrierte Schaltungsvorrichtung nach Anspruch 2, wobei der erste und der zweite integrierte Schaltungschip elektrisch miteinander verbunden sind.

4. Die integrierte Schaltungsvorrichtung nach Anspruch 2 oder 3, wobei der erste integrierte Schaltungschip ein Leistungschip ist und der zweite integrierte Schaltungschip ein Steuerchip ist, der konfiguriert ist zum Steuern des Betriebs des Leistungschips.

5. Die integrierte Schaltungsvorrichtung nach einem der Ansprüche 1 bis 4, wobei jede der dritten und vierten Seitenwände die V-förmige Vertiefung enthält.

6. Die integrierte Schaltungsvorrichtung nach einem der Ansprüche 1 bis 5, wobei die erste Außenecke definiert ist durch einen Außenwinkel α zwischen dem ersten Seitenwandabschnitt und dem zweiten Seitenwandabschnitt, und wobei die zweite Außenecke definiert ist durch den Außenwinkel α zwischen dem dritten Seitenwandabschnitt und dem vierten Seitenwandabschnitt.

7. Die integrierte Schaltungsvorrichtung nach einem der Ansprüche 1 bis 6, wobei die Innenecke definiert ist durch einen Innenwinkel β zwischen dem zweiten Seitenwandabschnitt und dem dritten Seitenwandabschnitt.

8. Die integrierte Schaltungsvorrichtung nach Anspruch 6 oder 7, wobei der Außenwinkel α eine Breite (W) der V-förmigen Vertiefung festlegt.

9. Die integrierte Schaltungsvorrichtung nach einem der Ansprüche 6 bis 8, wobei der Außenwinkel α eine Tiefe (D) der V-förmigen Vertiefung festlegt.

10. Die integrierte Schaltungsvorrichtung nach einem der Ansprüche 1 bis 9, wobei das Paket eine Dicke (T) hat und die V-förmige Vertiefung sich vollständig durch diese Dicke erstreckt.

## Revendications

1. Dispositif de circuit intégré (110), comprenant :
un boîtier (130) qui encapsule une grille de connexion (116) et au moins une puce de circuit intégré (112, 114), dans lequel l'au moins une puce de circuit intégré est montée sur un plot de puce (118, 120) de ladite grille de connexion, ladite grille comportant en outre une pluralité de conducteurs (122, 124) ;
dans lequel le boîtier présente, en vue de dessus, un périmètre carré ou rectangulaire défini par des première, deuxième, troisième et quatrième parois latérales (132) ;
dans lequel les première (132a) et deuxième (132b) parois latérales sont opposées l'une à l'autre ;
dans lequel les troisième (132c) et quatrième (132d) parois latérales sont opposées l'une à l'autre ;
dans lequel un premier ensemble (122) de la pluralité de conducteurs s'étend le long de la première paroi latérale et un deuxième ensemble (124) de la pluralité de conducteurs s'étend le long de la deuxième paroi latérale ; et
dans lequel au moins une parmi les troisième et quatrième parois latérales comporte une concavité en forme de V (140) et comprend :
une première partie de paroi latérale (142) ;
une deuxième partie de paroi latérale (144) connectée à la première partie de paroi latérale au niveau d'un premier coin extérieur (150) ;
une troisième partie de paroi latérale (146) connectée à la deuxième partie de paroi latérale au niveau d'un coin intérieur (152) ; et
une quatrième partie de paroi latérale (148) connectée à la troisième partie de paroi latérale au niveau d'un deuxième coin extérieur (154) ;
dans lequel la deuxième partie de paroi latérale et la troisième partie de paroi latérale définissent la concavité en forme de V ;
dans lequel la première partie de paroi latérale (142) s'étend perpendiculairement à partir de la première paroi latérale (132a), et la quatrième partie de paroi latérale (148) s'étend perpendiculairement à partir de la deuxième paroi latérale (132b),
**caractérisé en ce que** la concavité en forme de V a une largeur (W) entre les premier et deuxième coins qui est compris entre 0,35*L et 0,55*L, où L est une longueur de la troisième ou de la quatrième paroi latérale, et a une profondeur (D) à partir d'un plan de la troisième ou de la quatrième paroi latérale qui est comprise entre 0,15*L et 0,30*L.

2. Dispositif de circuit intégré selon la revendication 1, dans lequel le boîtier (130) encapsule une première puce de circuit intégré (112) et une deuxième puce de circuit intégré (114), la première puce de circuit intégré étant montée sur un premier plot de puce (118) de la grille de connexion et connectée électriquement à une première pluralité de conducteurs (122) de la grille de connexion, la deuxième puce de circuit intégré étant montée sur un deuxième plot de puce (120) de la grille de connexion et connectée électriquement à une deuxième pluralité de conducteurs (124) de la grille de connexion.

3. Dispositif de circuit intégré selon la revendication 2, dans lequel les première et deuxième puces de circuit intégré sont connectées électriquement l'une à l'autre.

4. Dispositif de circuit intégré selon la revendication 2 ou 3, dans lequel la première puce de circuit intégré est une puce de puissance et la deuxième puce de circuit intégré est une puce de commande configurée pour commander le fonctionnement de la puce de puissance.

5. Dispositif de circuit intégré selon l'une quelconque des revendications 1 à 4, dans lequel chacune des troisième et quatrième parois latérale
s comporte ladite concavité en forme de V.

6. Dispositif de circuit intégré selon l'une quelconque des revendications 1 à 5, dans lequel le premier coin extérieur est défini par un angle extérieur α entre la première partie de paroi latérale et la deuxième partie de paroi latérale, et dans lequel le deuxième coin extérieur est défini par l'angle extérieur α entre la troisième partie de paroi latérale et la quatrième partie de paroi latérale.

7. Dispositif de circuit intégré selon l'une quelconque des revendications 1 à 6, dans lequel le coin intérieur est défini par un angle intérieur β entre la deuxième partie de paroi latérale et la troisième partie de paroi latérale.

8. Dispositif de circuit intégré selon les revendications 6 ou 7, dans lequel l'angle extérieur α définit une largeur (W) de la concavité en forme de V.

9. Dispositif de circuit intégré selon l'une quelconque des revendications 6 à 8, dans lequel l'angle extérieur α définit une profondeur (D) de la concavité en forme de V.

10. Dispositif de circuit intégré selon l'une quelconque des revendications 1 à 9, dans lequel le boîtier a une épaisseur (T) , et dans lequel la concavité en forme de V s'étend complètement à travers ladite épaisseur.
